Europäisches Patentamt

European Patent Office

Office européen des brevets

(11) Publication number: **0 172 425**
**B1**

## EUROPEAN PATENT SPECIFICATION

(45) Date of publication of patent specification: **12.09.90**

(21) Application number: **85109137.1**

(22) Date of filing: **22.07.85**

(51) Int. Cl.⁵: **H 03 B 21/02, H 03 B 27/00**

(54) Signal synthesizer.

(30) Priority: **26.07.84 US 635312**
**30.07.84 US 635949**

(43) Date of publication of application:
**26.02.86 Bulletin 86/09**

(45) Publication of the grant of the patent:
**12.09.90 Bulletin 90/37**

(84) Designated Contracting States:
**DE FR GB**

(56) References cited:
**DE-A-2 828 224**
**US-A-2 864 956**
**US-A-2 920 284**
**US-A-3 854 102**

**HEWLETT-PACKARD JOURNAL, vol. 30, no. 1, 1979, pages 18-26; D.D. DANIELSON et al.: "A synthesized signal source with function generator capabilities"**

(73) Proprietor: **Hewlett-Packard Company**
**Mail Stop 20 B-O 3000 Hanover Street**
**Palo Alto California 94304 (US)**

(72) Inventor: **Smith, Larry James**
**2219 96th Place S.E.**
**Everett, WA 98204 (US)**
Inventor: **Spaulding, William M. Sr.**
**10607 32nd Drive S.E.**
**Everett, WA 98204 (US)**
Inventor: **Allen, Curtis M.**
**233 Dorn Avenue**
**Everett, WA 98204 (US)**

(74) Representative: **Williams, John Francis et al**
**J.F. Williams & Co 34 Tavistock Street**
**London WC2E 7PB (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to a signal synthesizer for providing output signals having predetermined relationship to each other with regard to phase or frequency.

US—A—2920284 discloses a signal synthesizer for providing output signals having a selectable relationship to each other with regard to phase comprising a first signal source, a common reference signal source, and two mixers.

It is known to phase lock a signal synthesizer to an external reference signal source in order to provide two output signals having the same frequency and variable phase offset. Such phase locked generators have disadvantages with regard to the accuracy of the phase offset between the output signals and are limited in that they only permit the adjustment of a fixed phase offset for a single frequency.

In view of this prior art, it is an object of the invention to create a signal synthesizer of the above-mentioned kind which can provide output signals having an adjustable phase or frequency offset over a wider frequency range.

According to the invention, this object is solved by the features of claim 1.

According to an underlying concept of the invention, the synthesizer comprises two channels with each channel having a signal source and a mixer for combining the output signal of the signal source with a reference signal to derive a synthesized signal for each channel, whereby the output signal of the signal source of one channel can be supplied to the mixer of other channel. The reference signal of one channel can be adjusted such as to have a predetermined phase offset or frequency offset with regard to the reference signal of the other channel. Since the mixers in the two channels receive the same signal at one of their inputs, the phase or frequency relationship between the two synthesized signals is maintained even when the frequency of the synthesized signals is swept over a wide frequency range.

In addition to its flexibility, the signal synthesizer according to the invention offers spectrally pure signals on each of the channels. In regard to operating modes of the synthesizer system, there are provided four new operating modes which are two channel mode, two phase mode, two tone mode, and pulse mode. Within each of these modes, a variety of modulations and waveforms are provided. Also, in addition to fixed synthesized frequencies, phase continuous sweeping is available in all modes. In the two channel mode, independent frequencies are available from the two output channels. When in the two phase mode, the frequency output of both channels is the same with an alterable phase offset of one channel with respect to the other channel. When in the two tone mode, different output frequencies are available from each channel with settable frequency offset. When in the pulse mode, a variable duty cycle square wave is output from one channel and its complement with respect to duty cycle is output from the other channel.

According to claim 3, the amplitudes of the output signals of the synthesizer can be adjusted.

According to claim 6, the phase difference between the two channels can be measured very precisely. The phase detector need not be as accurate as the desired phase results, since most phase detector circuit errors are cancelled out by averaging the results of two measurements with reversed inputs.

According to a preferred embodiment of the invention, the synthesizer provides three new configurations for the phase calibration system which are internal calibration, external calibration, and multi phase calibration. The internal calibration results in phase of one channel with respect to the other channel being calibrated at the outputs on the front panel. Phase calibration is done in the two phase mode for sine or square function or in the pulse mode. The external calibration allows phase calibration at a point external to the system. The phase calibration is done for the two phase mode in square or sine function. The multi phase calibration allows phase calibration of both signals with a third, external signal at the same frequency. Using several instruments in this fashion, this has the effect of providing multi channel phase calibrated signals.

In addition to these advantages described above, the synthesizer system of the present invention has the following contributions: First, the synthesizer provides phase continuity of the output signals during frequency sweeps. Second, use of one oscillator as a variable frequency reference allows the channel frequency to maintain a precise frequency offset from the other channel with minimal phase noise. Also, this precision offset is maintained during a sweep of the other channel. Third, with two channels in one instrument and the addition of the phase calibration system, very good phase accuracy is maintained. The phase calibration technique according to claim 6 allows theoretically zero phase error for equal level sines and the phase accuracy is substantially independent of the frequency. Furthermore, the invention permits to use an attenuator switching technique to characterize and correct for phase errors introduced by difference between levels in the two channels.

Subsequently, an embodiment of the invention is explained in detail with reference to the drawings.

Figure 1 is a simplified system block diagram of a preferred embodiment of the present invention illustrating the signal synthesizer system in the two channel mode.

Figure 2 is a simplified system block diagram of the embodiment illustrating the signal synthesizer system in the two phase mode.

Figure 3 is a simplified system block diagram of the embodiment illustrating the signal synthesizer system in the two tone mode.

Figure 4 is a simplified system block diagram of the embodiment illustrating the signal synthesizer system in the pulse mode.

Figure 5A—D are a detailed schematic diagram of the embodiment illustrating the detailed system configuration of the signal synthesizer system.

Figure 6 is a simplified system block diagram of the embodiment illustrating basic phase calibration system of the signal synthesizer system.

Figure 7 is a block diagram of phase calibration system of the signal synthesizer system illustrating calibration operation.

Figure 8 is a circuit diagram of a zero crossing detector consisting of the phase calibration system shown in Figure 7.

Figure 9 is a timing chart of the phase calibration system shown in Figure 7 to explain the relationship between input and output signals of the calibration system.

Figure 10AB is a transfer function diagram for the phase detector shown in Figure 7 to explain the relationship between two input signals.

Figure 11 is a simplified system block diagram of another embodiment of the invention illustrating an improved phase calibration system of the signal synthesizer system.

Figure 12A—C is a detailed circuit diagram of the embodiment illustrating the detailed circuit configuration of the phase calibration system of the signal synthesizer system.

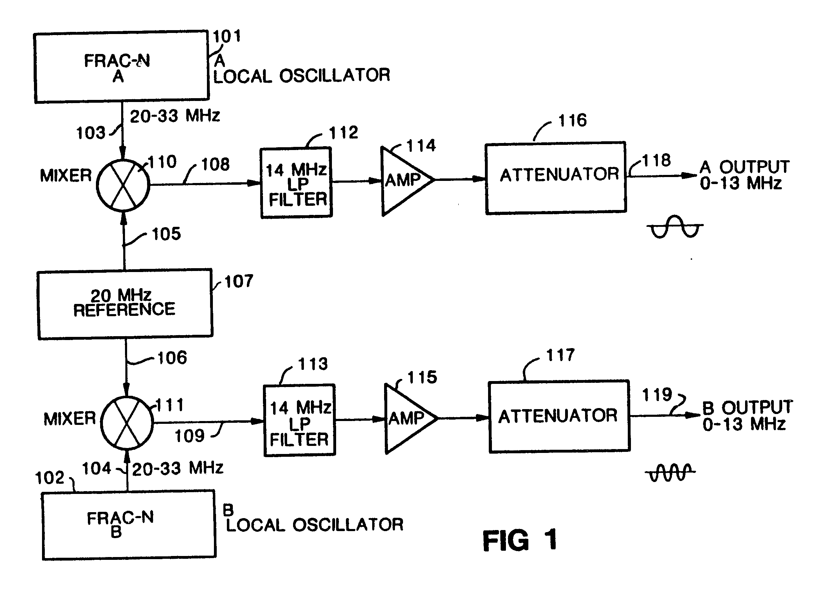

In Figure 1, an embodiment of the invention is shown as a system configuration. In this embodiment, the signal synthesizer system in two channel mode is configured as two independent synthesizers which are sharing a common frequency reference and controller. Namely, each channel A or B has a fractional-N based local oscillator 101 or 102 which is tunable from 20 to 33 MHz which microhertz resolution. The respective local oscillator signals 103 and 104 are mixed with fixed 20 MHz signals 105 and 106 from a common frequency reference 107 to obtain the desired 0 to 13 MHz signals 108 and 109 by mixers 110 and 111. The mixer outputs 108 and 109 are respectively low pass filtered to reject the high frequency images 14 MHz and above by low pass filters 112 and 113, and then amplified by amplifiers 114 and 115. Step attenuators 116 and 117 are used to provide 80 dB dynamic range of output levels. Hence, output signals 118 and 119 are respectively independent to provide variable frequency, spectrally pure signals from 0 to 13 MHz with sufficient gains as two separate synthesizers.

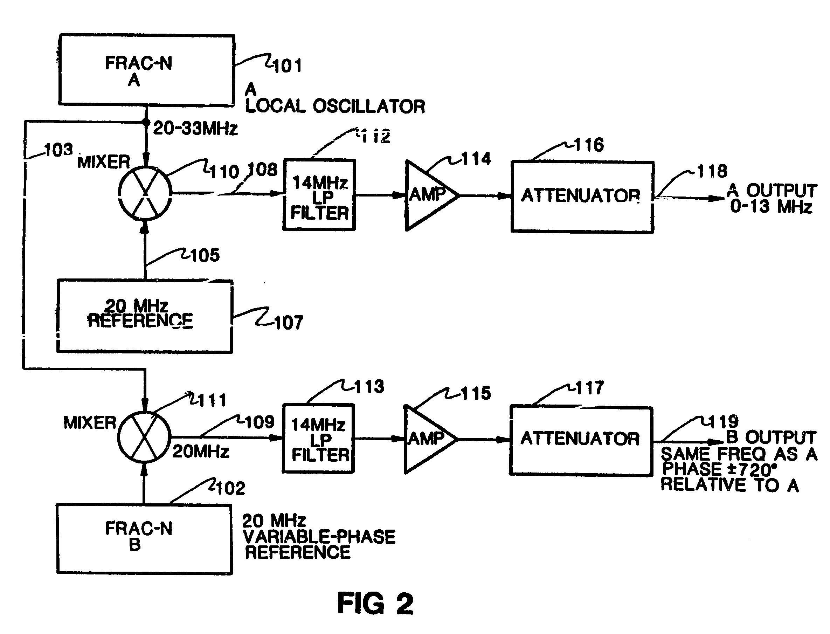

In Figure 2, the signal synthesizer system in two phase mode is also shown as a system configuration. The A channel consists of the local oscillator 101, the frequency reference 107, the mixer 10, the low pass filter 112, the amplifier 114, and the attenuator 116 is configured exactly as in two channel mode shown in Figure 1. However, for the B channel, the reference 107 and the local oscillator signal 103 are switched before the mixer 111 by a common controller such that the A fractional-N base local oscillator is the local oscillator for the B channel as well, and the B fractional-N base local oscillator is set to 20 MHz and is used as a reference whose phase can be precisely changed relative to the fixed reference 107. The fixed reference 107 is used for the A channel. This results in signals 118 and 119 at the outputs which have the same frequency with relative phase between B and A being settable to 0.01 degree resolution. As the A channel changes in frequency, the relative phase between B and A remains constant. Hence, the frequency can be the same for the output signals 118 and 119 with a variable phase offset of the B output signal 119 with respect to the A output signal 118. This leads the system to one of the particular contribution that the use of B oscillator 101 as a variable phase reference allows phase between the two channels A and B to be constant over frequency with good stability between calibration periods. This includes phase continuity through sweep.

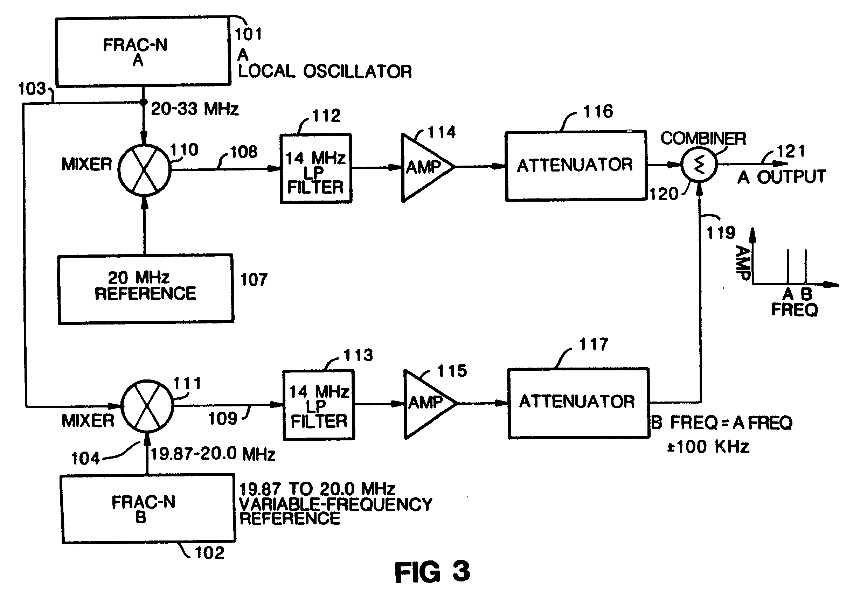

In Figure 3, the signal synthesizer system in two tone mode is also shown as a system configuration. The local oscillator and reference switching is identical to the two phase mode shown in Figure 2. Again, the B fractional-N base local oscillator 102 is used as a reference for the B channel. But, instead of changing the phase of the B local oscillator 102, the B local oscillator 102 is set to a frequency at 20 MHz plus some offset which is less than 100 KHz. This results in signals at the outputs 118 and 119 of the channels A and B which are offset in frequency by up to 100 KHz. An important benefit of this configuration is that as the A channel changes in frequency, the B channel automatically tracks while maintaining the precise frequency offset relative to the A channel. The channels A and B can be combined on single output 121 by a combiner 120. Hence, different output frequencies are available from each channel. This leads the system to an another particular contribution that the use of the B oscillator 102 as a variable frequency reference allows the B channel frequency to maintain a precise frequency offset from the A channel with minimal phase noise between the channels A and B. Also this precision offset is maintained during a sweep of the A channel.

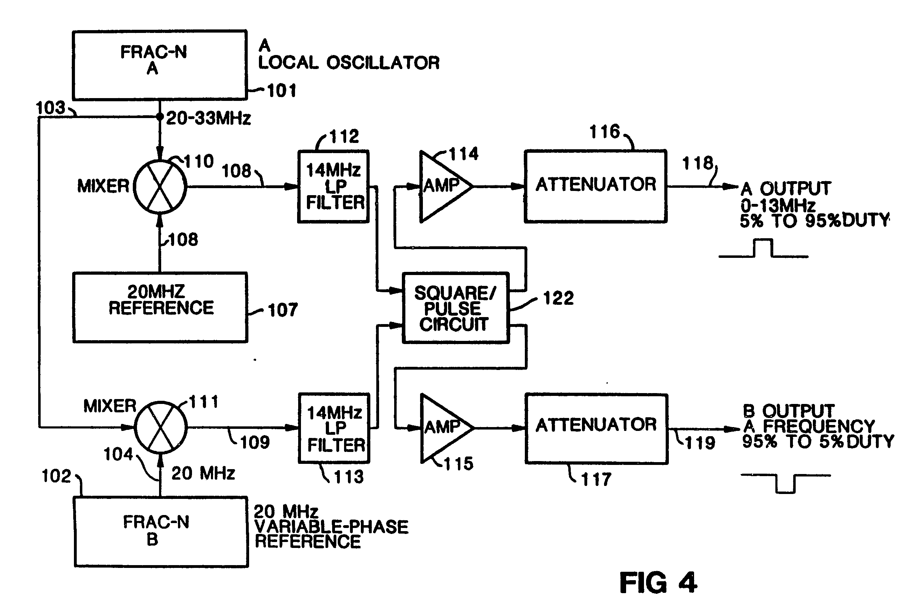

In Figure 4 the signal synthesizer system in pulse mode is also shown as a system configuration. The local oscillators 101 and 102, and the frequency reference 107 are switched exactly as in the two phase mode as shown in Figure 2 by the common controller. The distinction in Figure 4 is that before the output amplifiers 114 and 115, the sinewave signals 108 and 109 low pass filtered by the filters 112 and 113 are switched to a square/pulse circuit 122 which squares up and combines the signals in such a fashion as to yield a pulse waveform. The duty cycle reflects the phase difference between the A and B channels. The duty cycle is adjustable from 5% to 95%. This waveform is output on the A channel. For convenience, the complement of this waveform is available on the B channel. Hence, the signal outputs 118 and 119 are variable duty cycle square waves and are complementary to each other.

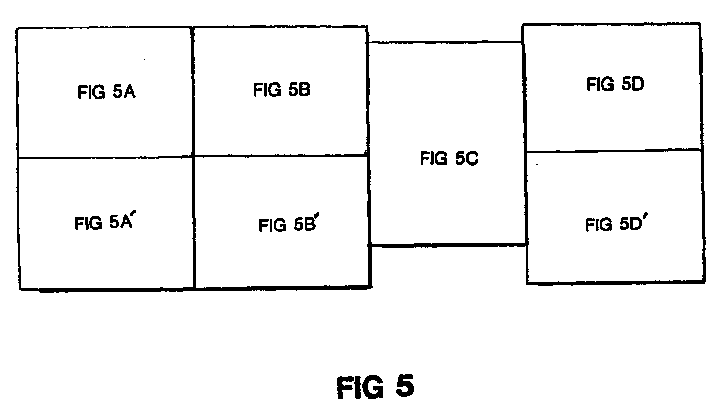

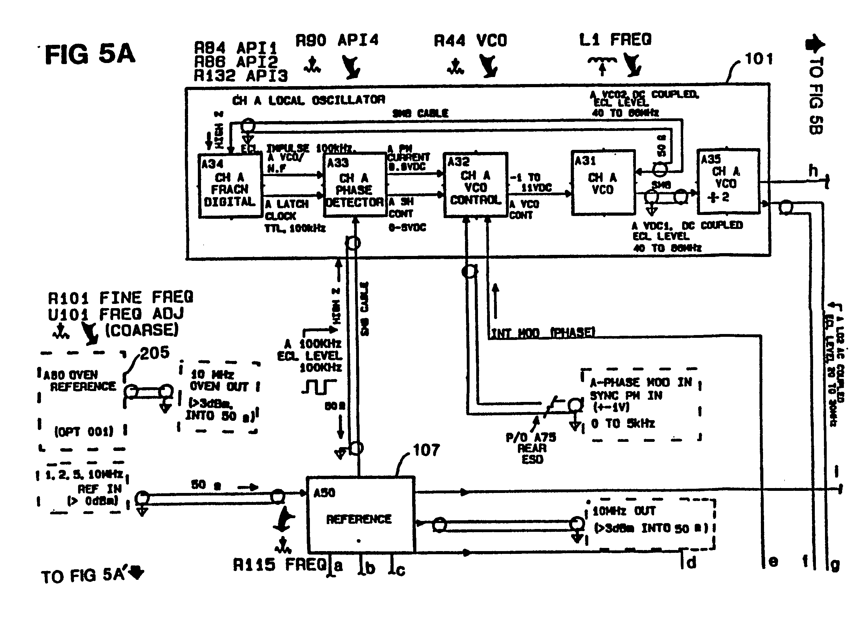

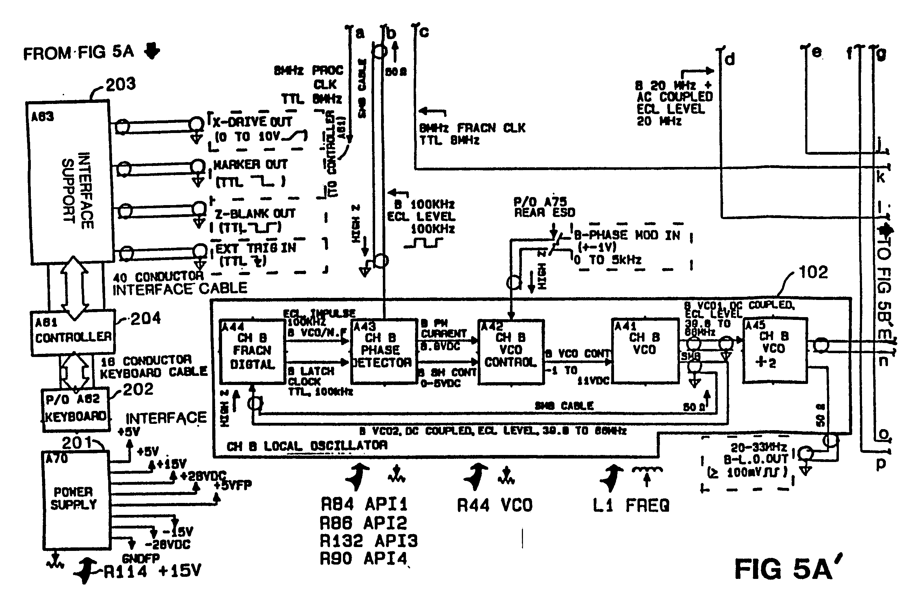

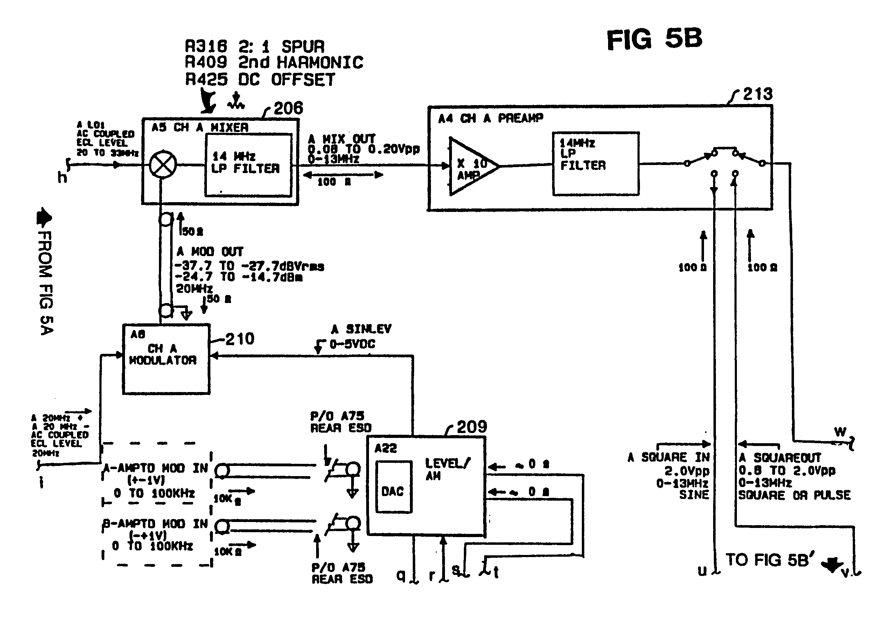

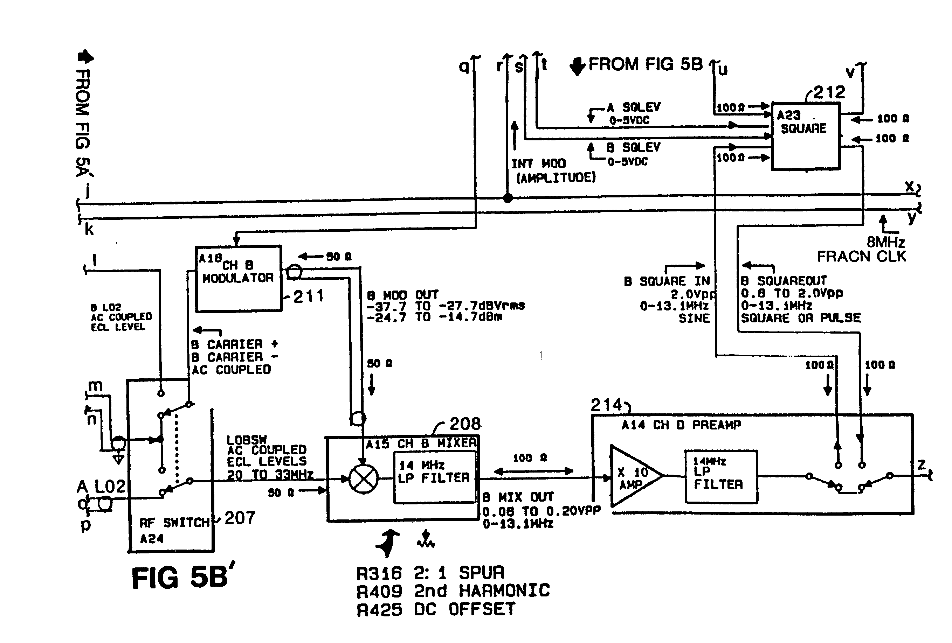

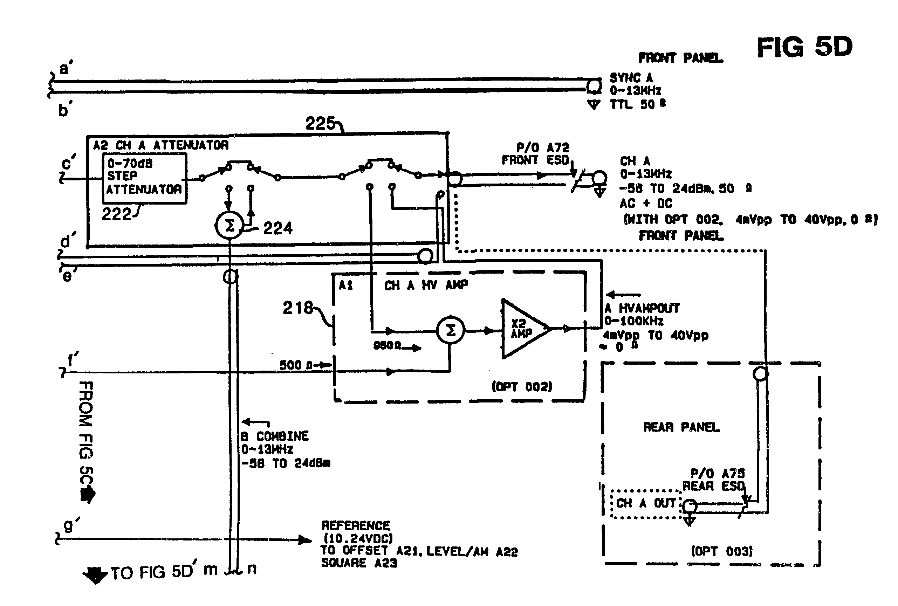

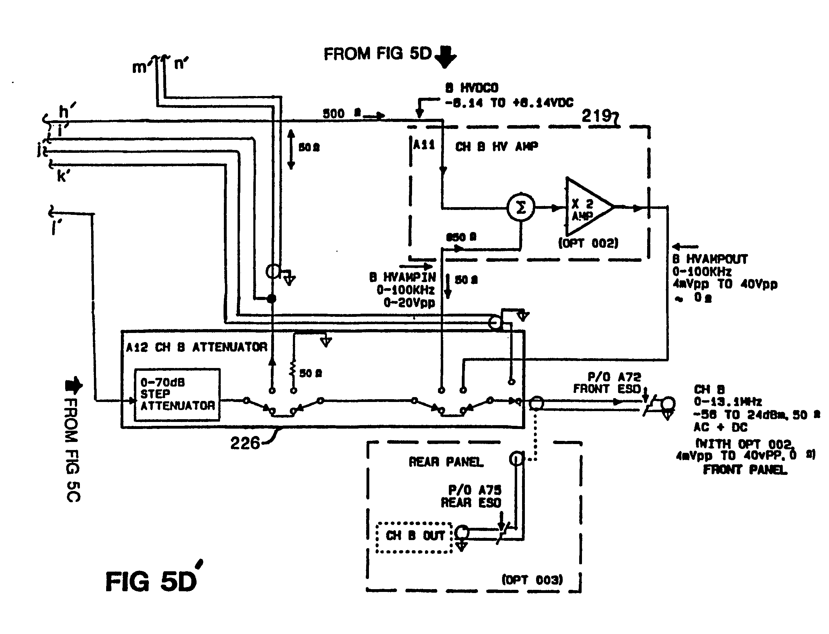

In Figure 5A—D detailed design of the simplified system block diagram of the embodiment in Figure 1 through Figure 4 is disclosed as a detailed schematic diagram.

Hereinafter, further features and modifications of the embodiment of the invention will be explained in regard to capabilities of sweep, functions, amplitude control, DC offset, modulation, combiner, calibration, oven reference, and high voltage option.

In all mode configurations, the sweep capability of the fractional-N oscillators can be used. Arbitrary start and stop frequencies and sweep times can be specified. Sweeps are phase continuous. Means are provided for starting the sweep from an external trigger with minimum delay.

Either square waves or sinewaves may be selected on each channel. The edges on the square wave coincide with the zero crossings of the sinewave. By suppressing AC, the outputs can be configured to generate only the DC offset level. Also, either of the outputs can be turned off entirely via a relay. Regardless of the function selected, a nominal 50 ohm source impedance is seen, unless the high voltage option is enabled in which case a low impedance which is less than 2 ohms is seen.

Amplitude can be controlled over a range from +23.97 dBm into 50 ohms, which is 10 volts peak to peak, to −56 dBm, which is 1 millivolt peak to peak. The combination of a selectable 10 dB attenuator before the output amplifier and a 0 dB to 70 dB step attenuator following the output amplifier allows the amplitude to be changed in 10 dB increments. The fine adjustment between 10 dB increments is provided by modulating the level of the 20 MHz reference signal before it gets into each mixer.

A DC offset can be added on top of the AC signal from each channel. Normally, this offset is injected before the output amplifier, so its maximum level is determined by the level of the AC signal. The instantaneous maximum level of DC plus AC cannot exceed the ±5 volt limits of the output amplifier. Also, the DC signal is attenuated right along with the AC as it passes through the output attenuator. If the high voltage option is selected, the DC offset is injected right at the high voltage amplifier so a large DC offset can be obtained, even if the AC signal level is highly attenuated.

The B channel output may be switched internally to become the level control for the A channel reference, thus allowing internal amplitude modulation on the A channel, or it can be switched into the phase control circuit of the A channel fractional-N oscillator, allowing internal phase modulation of the A channel. While internal modulation is enabled, the B channel output is disabled. Similarly, either channel A or B can be amplitude modulated, phase modulated, or both simultaneously from separate external inputs.

The outputs of the A and B channels can be as combined together into one output by enabling the internal combiner 120 as explained in Figure 3. Since this is a broad-band resistive combiner, the level of each signal drops to one-half.

The outputs of both channels A and B can be switched onto the calibrator circuit which is able to measure the amplitudes of either channel and relative phase between the two. Measurements taken are interpreted by the controller which in turn adjusts the level control or the fractional-N phase to correct for any error. During calibration, the signals are switched off at the outputs of the instrument. An alternate configuration provided is to measure the signals present on the rear panel "external cal" inputs. This allows "remote sensing" for phase cal which lets the user eliminate the effects of loss and phase shift in his cabling to the device under test. During either internal and external cal, the calibrator always measures phase of the "B" signal relative to "A" signal. The embodiment of this calibration system will be more precisely explained hereafter.

An oven-stabilized 10 MHz frequency reference option can be installed in the instrument. The output of the oven goes directly to the rear panel and must be jumped across to the "external reference" input when it is used.

An optional high voltage amplifier can be added to each channel. This amplifier following the attenuator gives four times the normal 50 ohm terminated level which is two times the normal open circuit level over a 0 Hz to 130 KHz range. The low impedance output of the high voltage amplifier is seen directly without any series backmatching resistance.

If the high voltage option is engaged, the DC offset is injected into the input of the high voltage amplifier instead of before the output amplifier. This allows a large DC offset to be provided with a small AC signal which has come through the output attenuator.

In referring to Figure 1 through Figure 5, the embodiment of the invention will be more fully described hereinafter as regards how the signal synthesizer system works.

As to power supplies and grounding, a linear power supply 201 having seven separate outputs is provided as shown in Figure 5A. Plus and minus fifteen volt supplies are used throughout the instrument. In addition, three separate five volt supplies are available. The main five volt supply is a highly regulated and very clean supply. It is used by most of the circuit assemblies wherever the demand is fairly constant or special isolation is not required. A separate five volt supply is necessary for the keyboard assembly 202 to keep the display scan frequency components out of the main five volt supply. The third five volt supply is used to power the interface support circuitry 203 which is IEEE standard 488 interface. Finally, a +28 and −28 supply provide power for the high voltage option.

Two separate grounds are maintained. The instrument enclosure is, of course, tied to earth ground via the line cord. The interface 203 ground is tied to the enclosure at a single point very close to the interface connector. To prevent low frequency ground loop problems and provide isolation, the instrument ground is separate from earth ground. This includes all of the internal card nests, motherboard, cables, etc. RF path are provided from instrument ground to earth ground via multiple capacitors and a varistor ensures that no more than 50 volts potential appears between the two grounds.

As to controller, all functions of the instrument are controlled by the 6809 microprocessor on the controller board 204, operating from 56 Kbytes of ROM. The controller 204 accepts commands in the form of keyboard entry or via the interface and controls each of the hardware assemblies via the instrument bus. The instrument bus is buffered and disabled any time that instructions are not actually being written to hardware to keep processor clock frequency from coupling to sensitive circuits.

Various hardware status lines and external synchronizing signals are monitored or set by the controller 204.

As to keyboard 202, the keyboard assembly 202 includes all switches and lights to interface with the operator. This includes 43 pushbutton switches, one rotary pulse generator (RPG), 49 individual LED's, 11 seven-segment digit displays, and 1 four-character alphanumeric display. The keyboard 202 is interfaced to the controller 204 via a bit-serial interface.

In addition, the keyboard 202 holds the synchronous circuit to keep it isolated from the clean output signals.

As to oven reference 205, option 1 provided for an overstabilized crystal reference 205 which is mounted below the power supply in the rear of the instrument 205. The output goes directly to the rear panel. To use the reference 205, it must be externally connected to the external reference input on the rear panel.

As to reference 107, the reference board generates all frequency references and clocks for the instrument. These include:

—Two 20 MHz reference signals which feed the "reference" ports of the channel A and B mixers 110 and 111.

—Two very clean 100 KHz clocks which provide the time base for the fractional-N circuitry of the two local oscillators.

—A 8 MHz clock for the controller board 204.

—A 10 MHz reference output available on the rear panel.

One input is available on the rear panel which accepts an external reference signal. If this signal is at a sub-harmonic of 10 MHz, the reference will synchronize with it.

As to local oscillators and switch, the A and B local oscillators 101 and 102 are identical fractional-N based synthesized oscillators. The five separate printed circuit assemblies make up each local oscillator (LO). In addition, there is a decoder circuit common to both local oscillators which reside on the calibrator board.

Each fractional-N oscillator is controllable via the instrument bus over a frequency range of 19.9 MHz to 33.0 MHz with one microhertz resolution. Both fractional-N oscillators can be adjusted for phase by incrementing or decrementing in as little as 0.001 degree steps. The fractional-N circuits do not remember where they have been programmed in the past, so any absolute phase reference must be remembered in the controller memory after performing a phase calibration by using the calibrator assembly.

Either fractional-N oscillator can be swept over any frequency in the 19.9 to 33.0 MHz range, either up or down, maintaining phase continuity during the sweep. Start and stop frequencies are settable to one microhertz resolution. During sweep, a "sweep limit flag" is available which signals when the fractional-N oscillator has passed a preprogrammed frequency within the frequency limits of the sweep. There are two separately buffered ECL level outputs on each LO. One output from the A LO 101 is permanently input to the A mixer LO port 206. The other A LO signal is input to the RF switch 207 where it is switched onto the B mixer LO port 208 for all operating modes other than two-channel.

One B LO signals goes to the RF switch 207 where it is switched onto either the LO port of the B mixer 208 in case of the two channel mode, or onto the reference port of the B mixer 208 in case of the other three modes. The second B LO signal is made available as a 20 to 33 MHz output on the rear panel.

As to level/AM control 209, the level/AM control assembly provides an audio frequency signal which either drives the A or B modulator 210 or 211 for sine operation, or drives the square wave circuit 212 for square or pulse operation. If no amplitude modulation signal is present, the output is a DC voltage proportional to the digital to analog converter (DAC) setting programmed by the controller 204. Separate digital to analog converters are provided for each of the two level outputs. If a modulation signal is persent, either internally from the channel B output, or externally from the rear panel inputs, the level outputs are proportional to both the DAC setting and the level of the modulating signal, subject to the 150 KHz bandwidth limit of the level control.

Programmable switches are provided to allow the controller 204 to specifiy either internal or external modulation for each level control, and to direct the output of each level control to either the sinewave modulator 210 or 211 or square wave circuit 212 of the respective A and B channels.

As to modulator, the modulator circuits 210 and 211 for each channel controls the level of the reference signal to the respective mixers 206 and 208 over a ten decibel range, thus controlling the level of the output signals from the instrument. Inputs to the A modulator 210 are the 20 MHz reference from the reference board 107 and the A level control signal from the level/AM board 209. The resulting level-controlled reference is band-pass filtered to eliminate harmonics of 20 MHz and limit noise outside a ± 100 KHz bandwidth around 20 MHz. The resulting "AMPOUT" output is input to the A mixer 206.

The modulator 211 operates in exactly the same fashion, except its 20 MHz input comes from the RF siwtch circuit 207.

As to mixers 206 and 208, the A and B channels use identical double-balanced, active mixers to heterodyne the 20 to 33 MHz (nominal) LO signal with the 20 MHz (nominal) reference signal to generate suppressed-reference double side-band products. The high sideband (40 to 53 MHz) as well as the residual 20 MHz reference signals are filtered out, yielding a "pure" signal of interest between 0 and 13 MHz with all other spurious and harmonic signals suppressed. The lowpass filter is split between the mixer board and the pre-amp to minimize the effect of interference along the interconnect path.

The active mixer design is optimized for low spurious and harmonic distortion.

As to pre-amp, the pre-amplifier circuit 213 or 214 contains the latter half of the first low-pass filter for each channel.

After filtering, the signal is amplified by a fixed gain (X10) amplifier; then it goes through an additional low pass filter before being passed on.

The output of the pre-amp is directed either directly to the output amplifier input, or to the square wave circuit using a controller programmed relay.

As to square circuit, the square wave circuit 212 has two functions. First, with the square wave function selected for either channel, that channel's signal is directed through the square circuit, which generates a crisp square wave output whose edges match the zero-crossings of the output of the pre-amp and whose amplitude is controlled by the level control from the level/AM circuit 209. Either A or B or both may have square function selected.

Secondly, in the pulse mode, the A output of the square wave circuit is a pulse waveforms whose pulse width reflects the phase difference between the A and B pre-amp outputs. The B output of the square circuit 212 is the logical complement of the A waveform.

As to offset control, the offset control circuit 215 generates a separate DC offset for each channel as determined by DAC's under processor control. Under normal operation, the offset signal is injected into the output amplifier summing node. If the high voltage option is enabled, the signal is injected into the summing node of the high voltage amplifier 218 or 219. A relay on the offset board directs it to one node or the other. Both channels have identical offset operation.

As to output amplifier, the output amplifier 216 or 217 boost the signal to its maximum level of up to ±5 volts into 50 ohms±10 volts open circuit).

The AC circuit path from the pre-amplifier 213 or 214 can be switched through a 10 dB attenuator 220 or 221. In most operating modes, this 10 dB pad is the first pad thrown in as amplitude is reduced. The benefits of having this first 10 dB before the amplifier include:

—Improved harmonic distortion on ranges 2 through 8, since output amplifier is driven at a much reduced level.

—Guaranteed DC offset for ranges 2 through 8. Since offset is injected after the 10 dB pad, headroom remains in the output amplifier 216 or 217 to provide substantial DC offset regardless of the AC level of the output.

—Phase calibration is improved by allowing the calibration level sensitivity and modulator phase as a function of level to be characterized in the calibration process.

The signal goes through an overload current sense circuit, and a 50 ohm backmatch resistor.

As to attenuator, the step attenuator 222 or 223 allows the amplitude of the output signal to be attenuated in 10 dB steps to as much as 70 dB, maintaining 50 ohm impedance throughout.

In addition to the attenuator 222 or 223, this printed circuit board contains additional overload sensing and a cutout relay for the overloads.

Also, a relay is provided to divert the signal from the attenuator input to the calibrator board.

Another relay re-directs the signal out of the attenuator 222 or 223 through the high voltage amplifier and back, when the option is selected.

Finally, if the combiner is engaged, both the A and B signals are input to a summing network 224 on the A attenuator 225. The combined signal is output on the A channel, and the B output is terminated with 50 ohms to ground. The presence of this network on A is the only distinction between the A and B attenuator circuits 225 and 226.

As to synchronous circuit (SYNC) 227, a small circuit which resides on the keyboard assembly taps off the output signal from the output amplifier 216 and generates a square wave whose edges are coincident with the zero-crossings of the waveform out of the amplifier. Because there may be some DC offset programmed, the SYNC circuit 227 also resquires a sample of the DC offset level to correct for this. The SYNC circuit 227 is available directly on the front panel after going through some protective circuitry.

As to calibration, the final block in the instrument signal chain is the calibration 228 which is capable of measuring DC offset, and peak-to-peak amplitude on both A and B channels and can measure phase between the channels very precisely.

Under control of the controller board 204, the calibrator takes data points, swapping back and forth between channels and alternately engaging or disengaging the 10 dB pad 220 or 221 on the output amplifier 216 or 217 while changing the levels of the modulators 210 and 211. The combinations of measurements made allows most systematic errors to be corrected for yielding very precise phase comparison between A and B.

As measurements are taken, the controller 204 iteratively changes the amplitude or phase parameter being calibrated to minimize error. In phase calibration, the controller "bumps" the phase of the fractional-N oscillator. During amplitude calibration, the controller changes the DAC settings on the level control circuit. And, during offset calibration, the controller changes the DAC settings on the offset control.

Besides the "internal" calibration configuration, where B phase is adjusted relative to A phase by internally sampling the two signals, two other configurations can be selected.

In "external" calibration, the signals present at the two rear panel calibration inputs are assumed to be the A and B signals measured at the end of a cable, or after being modified by some device under test. The calibration process is the same as with internal calibration.

In "multiphase" calibration, the A calibration input is expected to be a signal from another source, and the B input is expected to be the A output of the system. In this configuration, the phase of A is bumped to align the A channel with the output of the other source. The other source must have its reference locked with the system in order to get a successful phase calibration.

As explained in a previous section, the phase calibration system has an unique contribution to the signal synthesizer system such that with two channels in one instrument and the addition of the phase calibrator, very precise phase accuracy can be maintained. This phase calibration technique allows theoretically zero phase error for equal level sines, and utilizes a unique attenuator switching technique to characterize and correct for phase errors introduced by the difference between levels in the two channels.

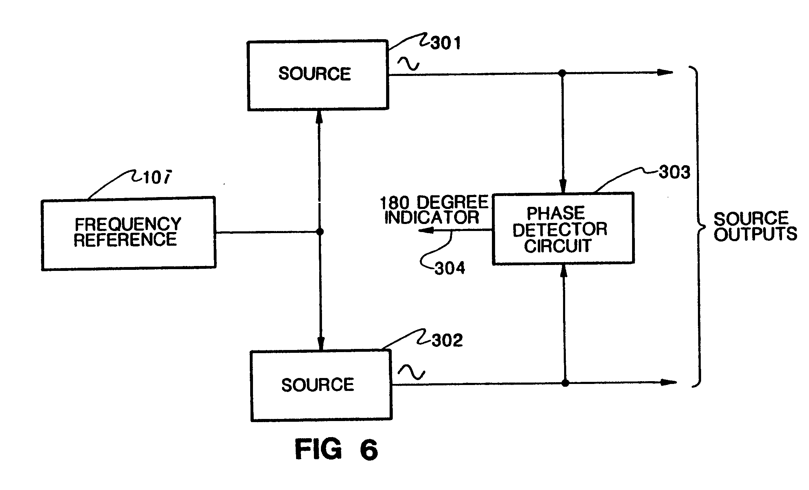

In referring to Figure 6 through Figure 12, the signal synthesizer system will be more fully described hereinafter as regards the phase calibration system.

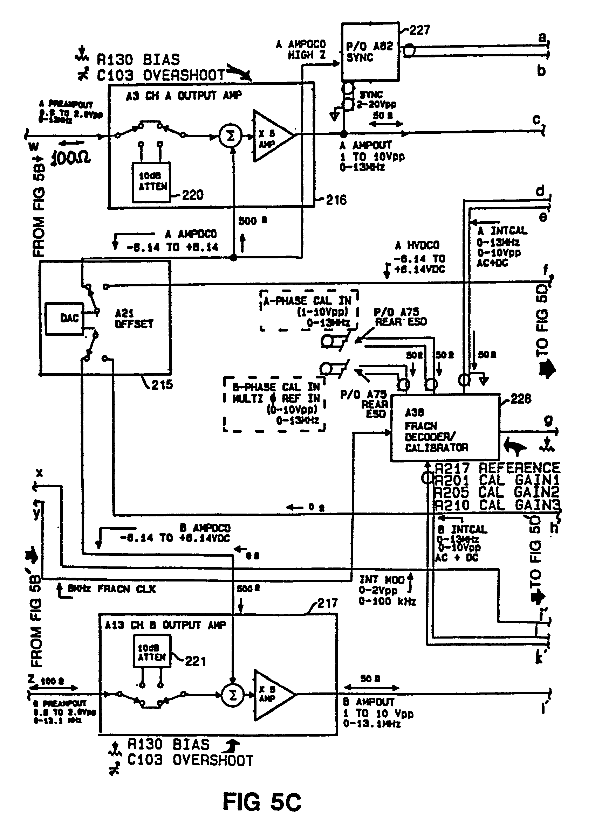

In Figure 6, the phase calibration system as a subsystem of the signal synthesizer system is shown in a basically simplified system block diagram. Namely, the frequency reference 107 is connected to two sources 301 and 302 which are already discussed hereinabove as the A and B channels in Figure 1 through Figure 5. The two sources 301 and 302 are programmable in frequency, amplitude, and phase, by the controller 204, and are phase locked to the frequency reference 107 as explained above. Both outputs of the sources 301 and 302 are fed to inputs of a phase detector circuit 303 which gives an indication of when the phase between its inputs is 180 degrees. This phase detector circuit 303 consists of the decoder/calibrator 228 shown in Figure 5C. As basic calibration scheme of the phase detector circuit 303 is as follows. First, the sources 301 and 302 are set up for frequency in which both sources are identical, as well as for amplitude. Second, the phase of one source 301 and 302 is varied until the phase detector circuit 303 indicates 18 degrees by a signal 304. Third, this point is defined as a 180 phase, and the desired phase offset is entered onto the sources 301 and 302 by the controller 204. Therefore, it is assumed that the phase of the sources 301 and 302 can be incremented very accurately, so that an accurate calibration to zero degrees will provide calibrated outputs from zero to 360 degrees.

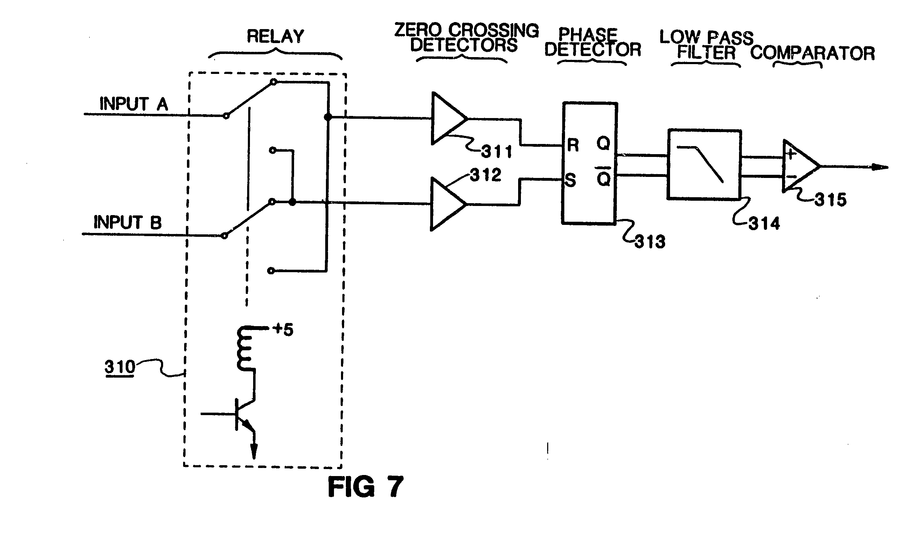

In Figure 7, the phase detector circuit 303 of Figure 6 is described as a block diagram. The phase detector circuit 303 consists of five blocks which are a relay 310 to reverse inputs, two zero crossing detectors 311 and 312, a flip-flop phase detector 313, a low pass filter 314, and a comparator 315. Each function of this block diagram will be clearly explained in the following description.

Function of the zero crossing detector 311 or 312 is to take an analog waveform and convert it to a digital waveform, transitions of which reflect the timing of the analog zero crossings. The zero crossing detectors 311 and 312 are optimized for speed, insensitivity to amplitude and DC offset of the input signals, as well as noise rejection. It is preferable to use integrated circuit comparators as a choice of design for the zero crossing detectors 311 and 312 which require very high speed, high gain, and low offset voltage at a good price/performance ratio.

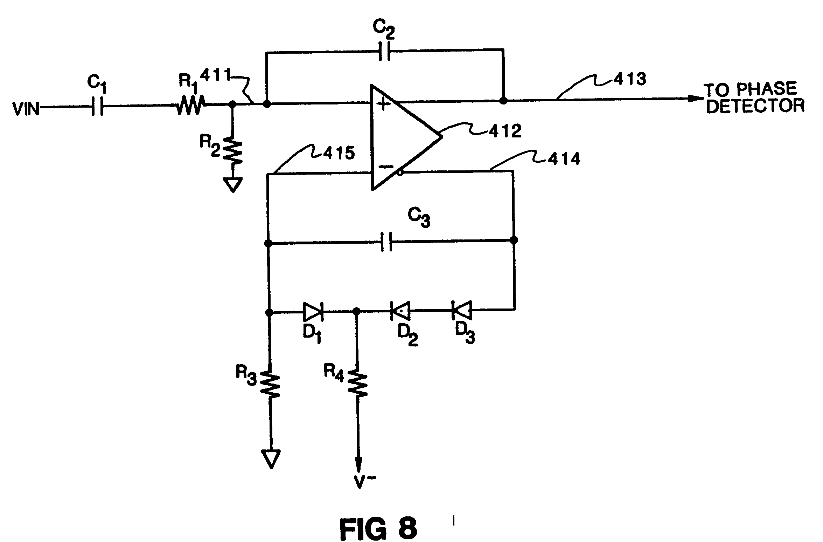

In Figure 8, the zero crossing detectors 311 and 312 are precisely shown as a circuit diagram. The input signals Vin are capacitively coupled through a capacitor $C_1$, to reject DC components, resistively divided through resistors $R_1$ and $R_2$, and connected to a non-inverting input 411 of a comparator 412. Two feedback paths, which are AC and DC feedback, are connected from comparator outputs 413 and 414 to its inputs 411 and 415. The AC feedback is differential, and consists of capacitors $C_2$ and $C_3$. As the input signal 411 crosses the comparator threshold, the outputs 413 and 414 change state, and couple a signal back to the inputs 411 and 415 in a regenerative manner. This positive feedback effect is very short lived, however, as an RC time constant at the inputs 411 and 415 is about one nanosecond. This allows high frequency circuit operation. The DC feedback path operates on the inverting input only, and consists of resistors $R_3$ and $R_4$, and diodes $D_1$, $D_2$ and $D_3$. When the input signal 411 is below the comparator threshold, the inverting output 414 is high, which forward biases the diodes $D_2$ and $D_3$, and reverse biases the diode $D_1$. Therefore, the inverting input 415 will be at ground potential. This sets the switching threshold to zero volts for signals crossing in the positive direction. Once the input signal 411 is above this threshold, the inverting output 414 goes down, which turns off the diodes $D_2$ and $D_3$, and allows the diode $D_1$ to become forward biased. The voltage at the inverting input 415 now is set by voltage division between the resistor $R_3$, the diode $D_1$, and the resistor $R_4$. This is then the threshold for signals crossing in the negative direction, which is designated to set to −50 mV.

The effect of this feedback is to implement hysteresis, which is necessary to allow the circuit to operate in the presence of noise. However, because the switching threshold for positive going signals is zero volts, the circuit still acts as a true (which means positive going) zero crossing detector. Timing of the comparator output transitions will then accurately reflect positive zero crossings, and show a small delay for negative zero crossings. The hysteresis is implemented in this manner because it is designed in order that the transition of importance on square or pulse waveforms is the rising edge, so that the circuit follows to react accurately these edges. The timing of negative zero crossings for both square and sine waves is not critical, because the flip-flop phase detector is clocked on rising edges only. The combination of AC and DC hysteresis gives this zero crossing detector the ability to accurately detect positive zero crossings, in the presence of noise, over a very broad frequency range.

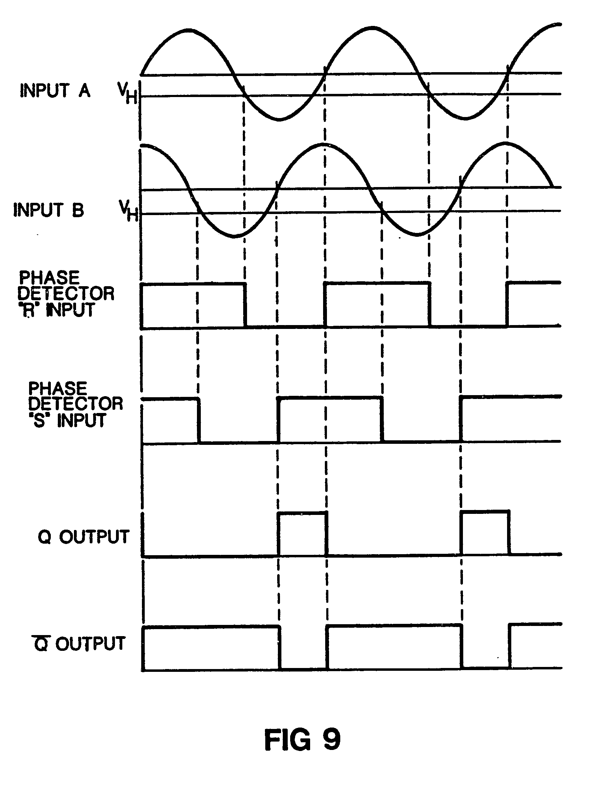

In referring to the timing chart of Figure 9, the function of the phase detector 313 will be explained. Namely, two interconnected flip-flops form the phase detector 313, which is driven by the outputs of the two zero crossing detectors 311 and 312. An output Q and its complement $\bar{Q}$ of the phase detector 313 are both used by the following circuitry. One zero crossing detector 312 acts to set the phase detector 313, while the other zero crossing detector 311 acts to reset the phase detector 313. The outputs Q and $\bar{Q}$ of the phase detector 313 are then squarewaves whose duty cycle is determined by timing of the set and reset inputs S and R, which ultimately reflect the phase between the two original input signals A and B. An input phase difference of 180 degrees will produce a 50% duty cycle phase detector output. The timing chart shows these signals A and B for an arbitrary input phase; in this case the input B leads the input A by 90 degrees. A negative hysteresis voltage $V_H$ of the zerocrossing detector 311 or 312 is shown much exaggerated for the clarity of this discussion.

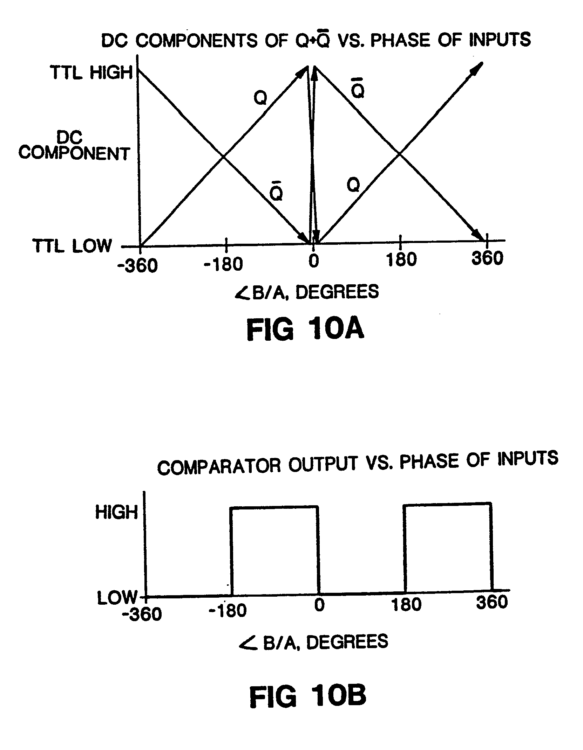

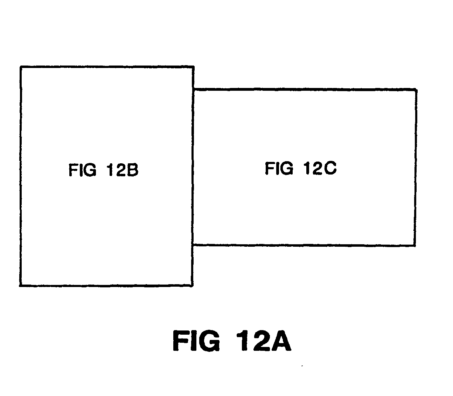

The high frequency operation of this phase detector 313 preferably dictates the use of a dual Schottky TTL flip-flop for the design. In referring to the phase diagram of Figure 10AB, both of the low pass filter 314 and the comparator 315 are functionally discussed in greater detail hereinbelow. The low pass filter 314 and the comparator 315 actually consist of two circuits respectively as shown in Figure 12A—C which shows the detailed circuit configuration of the calibration system for the design. The filter 314 and the comparator 315 signal the controller 214 when the phase of the input signals A and B passes through 180 degrees. In the following discussion, the two filters and the two comparators are respectively identical except filter cutoff frequency. The low path filter 314 acts differentially on the true output Q and the complement output $\bar{Q}$ of the phase detector 313, removing their AC components and presenting their DC components to the input of the comparator 315. As the phase between the input signals varies between 0 and 360 degrees, the true output Q of the phase detector 313 will vary from 0% duty cycle to 100%, hence its DC component will vary the TTL output level from low to high. The complement output $\bar{Q}$ will vary in the opposite manner for the same input phase change that the complement output Q will vary from 100% duty cycle to 0%, and that its DC component will vary the TTL output level from high to low. The two DC components will then cross each other when the input signal passes through 180 degrees, and the comparator output will change state, signalling the controller 204. This relationship is shown in Figure 10A which describes the relationship between the DC components of the outputs Q and $\bar{Q}$ and the phase of the inputs, and in Figure 10B which describes the relationship between the comparator output and the phase of the inputs. The two filters consisting of the filter 314 are included in the above discussion because circuit operation speed is directly proportional to filter cutoff frequency, or setting time. Low frequency inputs require use of the "slower" filter, while for higher frequency inputs the "fast" filter can be used.

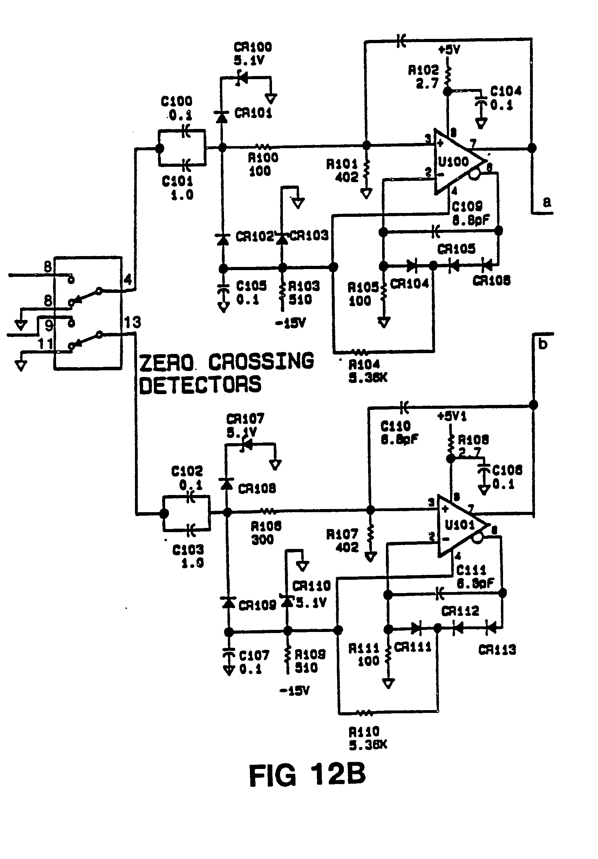

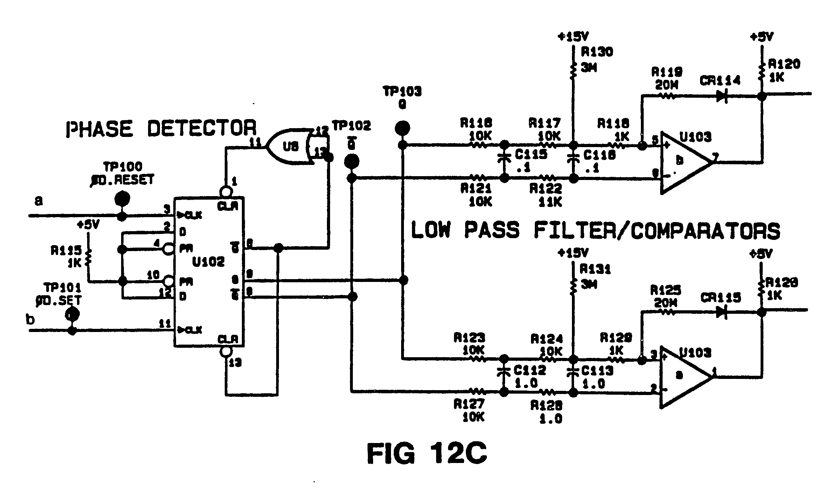

The high gain of the comparator 315 enhances the resolution of the entire phase detection scheme, as the volts/degree at the phase detector output is rather small, i.e., 3.6 volts per 360 degrees or 10 mV per degree. This figure is closer to 500 volts/degree at the comparator output. This allows the controller 204 to detect phase changes on the order of 0.003 degrees. Hence, the calibration system of the invention allows the controller based on a microprocessor to perform phase calibration and to measure and correct for the instrument's phase vs. amplitude chracteristic. The input reversing relay 310 is used to allow phase calibrations with the phase detector 313 hooked up normally or with its inputs reversed. By doing two calibrations, one with inputs reversed and one without, systematic errors can be eliminated by averaging the results obtained. The systematic errors should be considered as follows. The circuit shown in Figure 12 has several sources of error, such that 180 degrees may be indicated when there is actually a finite phase offset. These include:

(1) Unequal propagation delay in the two signal paths.

(2) Unequal high and low voltage levels for the phase detector outputs Q and $\bar{Q}$.

(3) Input offset voltage on the comparator.

(4) Input offset voltage on the zero crossing detectors.

(5) Crosstalk between the zero crossing detectors.

(One's output transition affecting the timing of the other.)

Herein lies one of the contributions of this phase calibration technique.

In referring to Figure 6 through 12, the embodiment of the invention is more fully described hereinbelow as regards the step by step procedure by which the phase calibration system works.

Step 1: The output signals A and B of the sources 301 and 302 are connected to the phase detector circuit 303 via the input reversing relay 310.

Step 2: The controller 204 increments the phase of the channel B until the phase detector 313 indicates that the phase of the channel B with respect to the channel A is between zero and 180 degrees.

Step 3: The phase of the channel B is incremented until the phase of the channel B with respect to the channel A just exceeds 180 degrees.

Step 4: The phase of the channel B is decremented until the phase of the channel B with respect to the channel A is just less than 180 degrees.

Step 5: Steps 3 and 4 are repeated alternately with the phase increments getting successively smaller in an approximately binary fashion. The initial increment is 90 degrees and the final is 0.009 degrees.

Step 6: The value of the phase of the channel B at the end of the step 5 is stored away.

Step 7: The inputs A and B of the phase detector 313 are reversed via the input reversing relay 310.

Step 8: The steps 3 through 5 are repeated, with the direction of all phase increments reversed.

Step 9: The value of the phase of the channel B resulting from the step 8 is averaged with the value stored in the step 6, and this angle is defined in the phase of the channel B with respect to the channel A equal to 180 degrees.

Step 10: The phase of the channel B is updated to reflect the phase of the channel B with respect to the channel A which the user has programmed (i.e., if zero degrees is programmed, the phase of the channel B will be decremented 180 degrees).

Step 11: The output signals A and B of the source 301 and 302 are disconnected from the phase detector.

At the end of the step 5 the phase detector circuit 303 indicates that the phase of the channel A with respect to the channel B is 180 degrees. However, real phase detector circuits are far from ideal in that errors will be introduced due to propagation delays, comparator offset voltages, electrical crosstalk, and many other factors as discussed as the systematic errors. Although the phase calibration system is designed to be as precise as possible, this result can be off by as much as several tenths of degrees at low frequencies, and as much as several tens of degrees at high frequencies. By reversing the inputs to the phase detector circuit and performing another calibration, an identical error is introduced, but with opposite sign. By averaging the results of the two calibrations, most phase detector circuit errors are effectively cancelled out.

The advantage of this calibration technique is that the phase detector need not be accurate as the desired phase results, but it merely needs to have very good resolution and be repeatable in the short term.

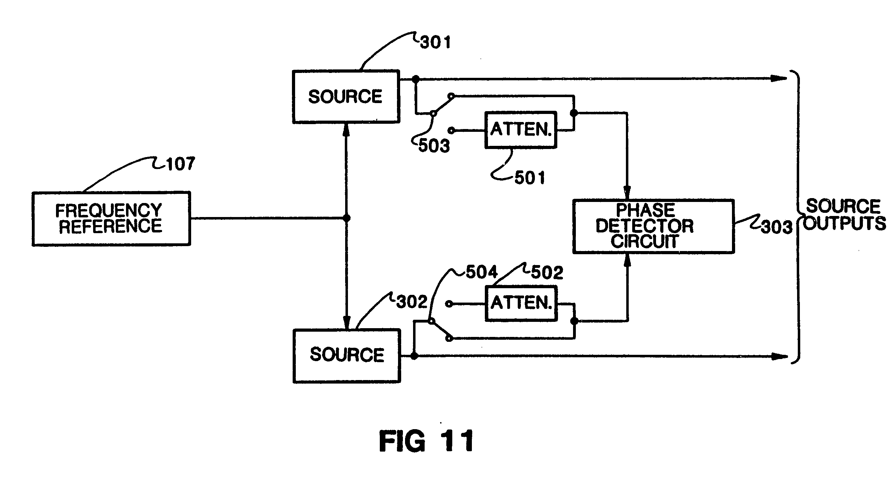

In referring to Figure 11, a modification of the embodiment of the calibration system will be discussed. In consideration of the systematic errors, another error source not compensated for by the two pass averaging technique described above is input offset voltage on the zero crossing detectors, when unequal amplitude input signals are calibrated. Two attenuators 501 and 502 have been added to the Figure 6. When the attenuators 501 and 502 are switched in by two switches 503 and 504, they attenuate the inputs to the phase detector circuit 303 by a given amount (10 dB in this case) and add negligible phase shift at the frequencies of interest. To remove the error discussed above, the following steps should be taken.

Step 1*: The sources 301 an 302 are set to the desired frequency and an arbitrary level, switches as shown in Figure 11.

Step 2*: A one pass phase calibration is performed.

Step 3*: One attenuator 501 is switched in.

Step 4*: Another calibration is performed, and the difference in phase between this result and that of Step 2* is recorded.

Step 5*: From the information obtained, the offset voltages for both zero crossing detectors can be calculated.

After performing the above steps, signals of differing amplitude can be phase calibrated, and correction factors are calculated from the known offset voltages.

The addition of these attenuators 501 and 502 has another advantage. Most sources show the tendency to vary the phase of their outputs as the amplitude is varied. This is undesirable, because a phase calibration is then only good for the signal amplitude chosen. By using the attenuators in the "put and take" technique described above, the source phase vs. amplitude characteristic can be approximated as follows.

Step 1**: One source 301 is set full scale and the associated attenuator 501 is switched in.

Step 2**: The other source 302 is set to an arbitrary level.

Step 3**: A one pass phase calibration is performed.

Step 4**: The first source 301 is reduced 10 dB and the attenuator 501 switched out. The amplitudes of the phase detector circuit 303 are unchanged.

Step 5**: Another phase calibration is performed, and this result is compared to that of Step 3**.

Step 6**: From this information, the phase vs. amplitude characteristic can be linearly approximated over the 10 dB range from the source 301 chosen.

Step 7**: Steps "1** through 7**" can be repeated for the other source 302.

With the information obtained above, errors can be minimized by changing phase when entering a desired amplitude change. This technique can be expanded by using multistep attenuators to obtain a multi-segment approxmation of the phase vs. amplitude characteristic.

## Claims

1. A signal synthesizer for providing output signals having a selectable relationship to each other with regard to phase or frequency, comprising: a first signal soruce (101) for providing a first signal having a variable frequency, a common reference signal source (107) for providing a reference signal having a predetermined frequency, a first mixer (110) having one input coupled to the first signal source and a second input coupled to the common reference signal source for providing a first synthesized signal having a selectable first frequency in response to the signals at its inputs; characterized by a second signal source (102) for providing a second signal having a variable frequency, a second mixer (111) having one input coupled to the second signal source (102) and a second input which can selectively be coupled either to the common reference signal source (107) or to the output of the first signal source (101) for providing a second synthesized signal having a selectable second frequency in response to the signals at its inputs, a common programmable control unit (204) coupled to the first and second signal sources (101, 102) for controlling phase and the frequency of the output signals of the signal sources (101, 102) such as to establish a selectable relationship with respect to phase or frequency between the first synthesized signal and the second synthesized signal.

2. A signal synthesizer as in claim 1, characterized in that the second mixer (111) is coupled to the output of the first signal source (101) and that the frequency of the output signal of the first signal source can be varied such as to provide synthesized signals having adjustable frequencies and a predetermined phase or frequency difference to each other, the difference remaining substantially constant when the frequency of the synthesized signals changes.

3. A signal synthesizer as in claim 1 or 2, characterized by
—a first low pass filter (112) coupled to receive the first synthesized signal,
—a first adjustable attenuator (116) for attenuating the output signal of the first low pass filter to provide a first output signal having an adjustable amplitude,
—a second low pass filter (113) coupled to receive the second synthesized signal,
—a second adjustable attenuator (117) for attenuating the output signal of the second low pass filter to provide a second output signal having an adjustable amplitude.

4. A signal synthesizer as in any of the preceding claims, characterized by a phase detector (303) for deriving a phase difference signal corresponding to the phase difference between the first synthesized signal and the second synthesized signal and for providing a calibrated phase between the first and the second synthesized signals.

5. A signal synthesizer as in claim 4, characterized in that the phase detector (303) is coupled to receive the first and the second synthesized signals for providing square wave signals being complementary to each other and having a duty cycle which is proportional to the phase difference between the first and second synthesized signals.

6. A signal synthesizer as in claim 4, characterized in that the phase detector comprises an input switch (310) having two possible switch positions, wherein in the first switch position the output of the first mixer (110) is coupled to a first input of the phase detector and the output of the second mixer (111) is coupled to a second input of the phase detector and wherein in the second switch position the output of the first mixer is coupled to the second input of the phase detector and the output of the second mixer is coupled to the first input of the phase detector, and that control means are provided for successively selecting the first and the second switch position and for determining from the two phase differences measured in the two switch positions a mean value for the phase difference.

7. A signal synthesizer as in any of the claims 4 to 6, characterized in that the phase detector comprises:
—two zero crossing detectors (311, 312), each coupled to a different input of the phase detector, for converting analog input signals to binary signals, and
—a circuit (313) coupled to the zero crossing detectors for providing a square wave output signal with the duty cycle of the square wave output signal corresponding to the phase difference between the input signals of the phase detector.

8. A signal synthesizer as in any of the preceding claims, characterized by sampling means included in the phase detector for internally sampling the first and second synthesized signals (108, 109) to calibrate the phase between the first and second synthesized signals.

9. A signal synthesizer as in claim 1, characterized in that the second mixer (111) is coupled to the common reference signal source (107) and that the frequencies of the output signals of the signal sources are adjustable independently of each other.

## Patentansprüche

1. Vorrichtung zum Erzeugen synthetischer Signale, wobei die Ausgangssignale der Vorrichtung zueinander eine wählbare Phasen- oder Frequenzbeziehung haben, mit einer ersten Signalquelle (101) zum Erzeugen eines ersten Signales mit einer variablen Frequenz, einer gemeinsamen Bezugssignalquelle (107) zum Erzeugen eines Bezugssignales mit einer vorbestimmten Frequenz und mit einem ersten Mischer (110), dessen einer Eingangsanschluß an die erste Signalquelle und dessen zweiter Eingangsanschluß an die gemeinsame Bezugssignalquelle angeschlossen sind, um ein erstes synthetisches Signal mit einer wählbaren ersten Frequenz in Abhängigkeit von den Signalen an seinen Eingangsanschlüssen zu erzeugen; gekennzeichnet durch eine zweite Signalquelle (102) zum Erzeugen eines zweiten Signales mit einer variablen Frequenz, einen zweiten Mischer (111) mit einem ersten an die zweite Signalquelle (102) angeschlossenen Eingangsanschluß und einem zweiten Eingangsanschluß, der wählbar entweder an die gemeinsame Bezugssignalquelle (107) oder an den Ausgangsanschluß der ersten Signalquelle (101) angeschlossen werden kann, um ein zweites synthetisches Signal mit einer wählbaren zweiten Frequenz in Abhängigkeit von den Signalen an seinen Eingangsanschlüssen zu erzeugen, eine gemeinsame programmierbare Überwachungseinheit (204), die an die erste und die zweite Signalquelle (101, 102) angeschlossen ist, um die Phase und die Frequenz der Ausgangssignale der Signalquellen (101, 102) derart zu überwachen, daß ein wählbares Phasen- oder Frequenzverhältnis zwischen dem ersten synthetischen Signal und dem zweiten synthetischen Signal eingestellt ist.

2. Vorrichtung zum Erzeugen synthetischer Signale nach Anspruch 1, dadurch gekennzeichnet, daß der zweite Mischer (111) an dem Ausgangsanschluß der ersten Signalquelle (101) angeschlossen ist und daß die Frequenz des Ausgangssignales der ersten Signalquelle so verändert werden kann, daß synthetische Signale mit einstellbaren Frequenzen und einer vorbestimmten Phasen- oder Frequenzdifferenz zueinander erzeugt werden, wobei die Differenz im wesentlichen konstant bleibt, wenn sich die Frequenz der synthetischen Signale ändert.

3. Vorrichtung zum Erzeugen synthetischer Signale nach Anspruch 1 oder 2, gekennzeichnet durch

—ein erstes Tiefpaßfilter (112), das zum Empfang des ersten synthetischen Signales verschaltet ist,

—ein erstes einstellbares Dämpfungsglied (116) zum Dämpfen des Ausgangssignales des ersten Tiefpaßfilters, um ein erstes Ausgangssignal mit einstellbarer Amplitude zu erzeugen,

—ein zweites Tiefpaßfilter (113), das zum Empfang des zweiten synthetischen Signales verschaltet ist,

—ein zweites einstellbares Dämpfungsglied (117) zum Dämpfen des Ausgangssignales des zweiten Tiefpaßfilters, um ein zweites Ausgangssignal mit einstellbarer Amplitude zu erzeugen.

4. Vorrichtung zum Erzeugen synthetischer Signale nach einem der vorangehenden Ansprüche, gekennzeichnet durch einen Phasendetektor (303) zum Gewinnen eines Phasendifferenzsignales, welches der Phasendifferenz zwischen dem ersten synthetischen Signal und dem zweiten synthetischen Signal entspricht, und zum Erzeugen einer kalibrierten Phase zwischen dem ersten und dem zweiten synthetischen Signal.

5. Vorrichtung zum Erzeugen synthetischer Signale nach Anspruch 4, dadurch gekennzeichnet, daß der Phasendetektor (303) so verschaltet ist, daß er das erste und das zweite synthetische Signal empfängt, um Rechtecksignale zu erzeugen, welche zueinander komplementär sind und ein Tastverhältnis haben, das der Phasendifferenz zwischen dem ersten und dem zweiten synthetischen Signal proportional ist.

6. Vorrichtung zum Erzeugen synthetischer Signale nach Anspruch 4, dadurch gekennzeichnet, daß der Phasendetektor einen Eingangsschalter (310) mit zwei möglichen Schaltpositionen umfaßt, wobei in der ersten Schaltposition der Ausgangsanschluß des ersten Mischers (110) an einen ersten Eingangsanschluß des Phasendetektors und der Ausgangsanschluß des zweiten Mischers (111) an einen zweiten Eingangsanschluß des Phasendetektors angeschlossen sind und wobei in der zweiten Schaltposition der Ausgangsanschluß des ersten Mischers an den zweiten Eingangsanschluß des Phasendetektors und der Ausgangsanschluß des zweiten Mischers an den ersten Eingangsanschluß des Phasendetektors angeschlossen sind, und daß Steuermittel vorgesehen sind zum nacheinander Auswählen der ersten und der zweiten Schaltposition und zum Ermitteln eines Mittelwertes für die Phasendifferenz aus den beiden in den beiden Schaltpositionen gemessenen Phasendifferenzen.

7. Vorrichtung zum Erzeugen synthetischer Signale nach einem der Ansprüche 4 bis 6, dadurch gekennzeichnet, daß der Phasendetektor umfaßt:

—zwei Nulldurchgangs-Detektoren (311, 312), die jeweils an unterschiedliche Eingangsanschlüsse des Phasendetektors angeschlossen sind, zum Umwandeln analoger Eingangssignale in binäre Signale, und

—eine Schaltung (313), die an die Nulldurchgangs-Detektoren angeschlossen ist, zum Erzeugen eines Rechteck-Ausgangssignales, wobei das Tastverhältnis des Rechteck-Ausgangssignales der Phasendifferenz zwischen den Eingangssignalen des Phasendetektors entspricht.

8. Vorrichtung zum Erzeugen synthetischer Signale nach einem der vorangehenden Ansprüche, gekennzeichnet durch Abtastmittel in dem Phasendetektor zum internen Abtasten des ersten und des zweiten synthetischen Signales (108, 109), um die Phase zwischen dem ersten und dem zweiten synthetischen Signal zu kalibrieren

9. Vorrichtung zum Erzeugen synthetischer Signale nach Anspruch 1, dadurch gekennzeichnet, daß der zweite Mischer (111) an die gemeinsame Bezugssignalequelle (107) angeschlossen ist und daß die Frequenzen der Ausgangssignale der Signalquellen unabhängig voneinander einstellbar sind.

**Revendications**

1. Un synthétiseur de signaux destiné à fournir des signaux de sortie présentant entre eux un rapport qui peut être choisi en ce qui concerne la phase ou la fréquence, comprenant: une première source de signaux (101) pour fournir un premier signal possédant une fréquence variable, une source commune de signal référence (107) pour fournir un signal de référence possédant une fréquence prédéterminée, un premier mélangeur (110) comportant une entrée couplée à la première source de signaux et une deuxième entrée couplée à la source commune de signal de référence pour fournir un premier signal synthétisé comportant une première fréquence susceptible d'être choisie en réponse aux signaux à ses entrées; caractérisé par une deuxième source de signaux (102) pour fournir un deuxième signal possédant une fréquence variable, un second mélangeur (111) possédant une entrée couplée à ladite deuxième source de signaux (102) et une deuxième entrée qui peut, de façon sélective, être couplée soit à la source commune de signal de référence (107) soit à la sortie de la première source de signaux (101) pour fournir un deuxième signal synthétisé possédant une deuxième fréquence qui peut être choisie en réponses aux signaux à ses entrées, une unité commune de commande (204), qui peut être programmée, couplée aux première et deuxième source de signaux (101, 102) pour commander la phase de la fréquence des signaux de sortie des sources de signaux (101, 102) de façon à établir une relation qui peut être choisie en ce que concerne la phase ou la fréquence entre le premier signal synthétisé et le deuxième signal synthétisé.

2. Un synthétiseur de signaux selon la revendication 1, caractérisé en ce que le deuxième mélangeur (111) est couplé à la sortie de la première source de signaux (101) en ce que la fréquence du signal de sortie de la première source de signaux peut varier de façon à fournir des signaux synthétisés possédant des fréquences qui peuvent être ajustées et une différence de phases ou de fréquence entre eux qui est prédéterminée, la différence restant sensiblement constant lorsque la fréquence des signaux synthétisés varie.

3. Un synthétiseur de signaux selon la revendication 1 ou 2, caractérisé par
—un premier filtre passe-bas (112) couplé pour recevoir le premier signal synthétisé,
—un premier atténuateur (116) qui peut être ajusté pour atténuer le signal de sortie du premier filtre passe-bas pour fournir un premier signal de sortie possédant une amplitude qui peut être ajustée,
—un deuxième filtre passe-bas (113) couplé pour recevoir le deuxième signal synthétisé,
—un deuxième atténuateur (117) qui peut être ajusté pour atténuer le signal de sortie du deuxième filtre passe-bas pour fournir un deuxième signal de sortie possédant une amplitude qui peut être ajustée.

4. Un synthétiseur de signaux selon l'une quelconque des précédentes revendications, caractérisé par un détecteur de phase (303) pour dériver un signal de différence de phase correspondant à la différence de phase entre le premier signal synthétisé et le deuxième signal synthétisé et pour fournir une phase étalonnée entre les premier et deuxième signaux synthétisés.

5. Un synthétiseur de signaux selon la revendication 4, caractérisé en ce que le détecteur de phase (303) est couplé pour recevoir le premier et le deuxième signaux synthétisés pour fournir des signaux à ondes carrées qui sont complémentaires l'un de l'autre et possèdent un cycle opératoire qui est proportionnel à la différence de phases entre les premier et deuxième signaux synthétisés.

6. Un synthétiseur de signaux selon la revendication 4, caractérisé en ce que le détecteur de phases comprend un commutateur d'entrée (310) possédant deux positions possibles de commutation, dans lequel, dans la première position de commutation la sortie du premier mélangeur (110) est couplée à une première entrée du détecteur de phases et la sortie du deuxième mélangeur (111) est couplée à une deuxième entrée du détecteur de phases et dans lequel, dans la deuxième position de commutation, la sortie du premier mélangeur est couplée à la deuxième entrée du détecteur de phases et la sortie du deuxième mélangeur est couplée à la première entrée du détecteur de phases, et
en ce qu'il existe des moyens de commande pour choisir successivement la première et la deuxième positions de commutation et pour déterminer à partir des deux différences de phases mesurées dans les deux positions de commutation une valeur moyenne de la différence de phase.

7. Un synthétiseur de signaux selon l'une quelconque des revendications 4 à 6, caractérisé en ce que le détecteur de phases comprend:
—deux détecteurs de passage à zéro (311, 312), couplés chacun à une entrée différente du détecteur de phases, pour convertir des signaux analogiques d'entrée en signaux binaires, et
—un circuit (313) couplé aux détecteurs de passage par zéro pour fournir un signal de sortie à ondes carrées, le cycle opératoire du signal de sortie à ondes carrées correspondant à la différence de phases entre les signaux d'entrée du détecteur de phases.

8. Un synthétiseur de signaux selon l'une quelconque des précédentes revendications, caractérisé par des moyens d'échantillonnage compris dans le détecteur de phases pour échantillonner de façon interne les premier et deuxième signaux synthétisés (108, 109) pour étalonner la phase entre les premier et deuxième signaux synthétisés.

9. Un synthétiseur de signaux selon la revendication 1, caractérisé en ce que le deuxième mélangeur (111) est couplé à la source commune de signal de référence (107) et en ce que les fréquences des signaux de sortie des sources de signaux peuvent être ajustées indépendamment l'une de l'autre.

FIG 1

A LOCAL OSCILLATOR

FRAC-N A — 101

20-33 MHz — 103

MIXER — 110

105

20 MHz REFERENCE — 107

14 MHz LP FILTER — 112

108

AMP — 114

112

ATTENUATOR — 116

118

A OUTPUT 0-13 MHz

B LOCAL OSCILLATOR

FRAC-N B — 102

20-33 MHz — 104

MIXER — 111

106

14 MHz LP FILTER — 113

109

AMP — 115

ATTENUATOR — 117

119

B OUTPUT 0-13 MHz

1

**FIG 2**

EP 0 172 425 B1

FIG 3

FIG 4

| FIG 5A | FIG 5B | | FIG 5D |
|--------|--------|--------|--------|
| FIG 5A′ | FIG 5B′ | FIG 5C | FIG 5D′ |

# FIG 5

**FIG 5A**

TO FIG 5B

101

CH A LOCAL OSCILLATOR

R84 API1  R90 API4  R44 VCO  L1 FREQ
R86 API2
R132 API3

A34 CH A FRACN DIGITAL

A33 CH A PHASE DETECTOR

A32 CH A VCO CONTROL

A31 CH A VCO

A35 CH A VCO ÷2

A50 REFERENCE

107

R101 FINE FREQ
U101 FREQ ADJ (COARSE)

205

A80 OVEN REFERENCE

(OPT 001)

1, 2, 5, 10MHz REF IN

10 MHz OVEN OUT

INT MOD (PHASE)

A-PHASE MOD IN
SYNC PM IN

P/O A75 REAR ESD

10MHz OUT

R115 FREQ

TO FIG 5A'

FIG 5A'

FIG 5B

FROM FIG 5A'

q r s t ↓ FROM FIG 5B ↑u v

212

A SQLEV
0-5VDC

100 Ω → A23 SQUARE ← 100 Ω

B SQLEV
0-5VDC

100 Ω → ← 100 Ω

INT MOD
(AMPLITUDE)

j

100 Ω

x

k

y

8MHz
FRACN CLK

A18 CH B MODULATOR

← 50 Ω

211

B MOD OUT
-37.7 TO -27.7dBVrms
-24.7 TO -14.7dBm

B SQUARE IN
2.0Vpp
0-13.1MHz
SINE

B SQUAREOUT
0.6 TO 2.0Vpp
0-13.1MHz
SQUARE OR PULSE

l

B LO2
AC COUPLED
ECL LEVEL

B CARRIER +
B CARRIER -
AC COUPLED

50 Ω

214

A14 CH D PREAMP

100 Ω

100 Ω

m

n

LOBSW
AC COUPLED
ECL LEVELS
20 TO 33MHz

208

A15 CH B MIXER

14 MHz
LP FILTER

100 Ω

X 10
AMP

14MHz
LP FILTER

z

A LO2

o

p

50 Ω

RF SWITCH 207
A24

B MIX OUT
0.06 TO 0.20VPP
0-13.1MHz

FIG 5B'

R316 2:1 SPUR
R409 2nd HARMONIC
R425 DC OFFSET

EP 0 172 425 B1

**FIG 5C**

**FIG 5D**

FRONT PANEL

a'

SYNC A
0-13MHz
TTL 50 Ω

b'

225

A2 CH A ATTENUATOR

P/O A72
FRONT ESD

c'

0-70dB
STEP
ATTENUATOR

222

CH A
0-13MHz
-58 TO 24dBm, 50 Ω
AC + DC
(WITH OPT 002, 4mVpp TO 40Vpp, 0 Ω)

Σ 224

d'

FRONT PANEL

e'

A1   CH A HV AMP

218

A HVAMPOUT
0-100KHz
4mVpp TO 40Vpp
~ 0 Ω

950Ω

Σ

X2
AMP

f'

500 Ω

(OPT 002)

FROM FIG 5C

REAR PANEL

B COMBINE
0-13MHz
-58 TO 24dBm

P/O A75
REAR ESD

CH A OUT

g'

REFERENCE
(10.24VDC)
TO OFFSET A21, LEVEL/AM A22
SQUARE A23

(OPT 003)

TO FIG 5D' m   n

FIG 5D'

FROM FIG 5D

FROM FIG 5C

FIG 6

FIG 7

ZERO CROSSING
DETECTORS

PHASE
DETECTOR

LOW PASS
FILTER COMPARATOR

RELAY

INPUT A

INPUT B

+5

FIG 8

EP 0 172 425 B1

INPUT A  V$_H$

INPUT B  V$_H$

PHASE
DETECTOR
'R' INPUT

PHASE
DETECTOR
'S' INPUT

Q OUTPUT

$\overline{Q}$ OUTPUT

**FIG 9**

16

DC COMPONENTS OF Q+$\bar{Q}$ VS. PHASE OF INPUTS

TTL HIGH

DC
COMPONENT

Q

$\bar{Q}$

$\bar{Q}$

Q

TTL LOW

-360    -180    0    180    360

∠B/A, DEGREES

## FIG 10A

COMPARATOR OUTPUT VS. PHASE OF INPUTS

HIGH

LOW

-360    -180    0    180    360

∠ B/A, DEGREES

## FIG 10B

**FIG 11**

FIG 12B

FIG 12C

# FIG 12A

**FIG 12B**

FIG 12C